# FASCICULE DE BREVET EUROPEEN

(11) **EP 1 287 171 B1**
(45) Date de publication et mention de la délivrance du brevet: **28.11.2012**
(21) Numéro de dépôt: 01938315.7
(22) Date de dépôt: 23.05.2001
(51) Int. Cl.: C21D 6/00, C21D 6/02, C22C 38/44, C22C 38/58, C22C 38/02, C22C 38/52, H01L 23/495

(54) **ALLIAGE FE-NI DURCI POUR LA FABRICATION DE GRILLES SUPPORT DE CIRCUITS INTEGRES ET PROCEDE DE FABRICATION**
AUSSCHEIDUNGSGEHÄRTETE FE-NI-LEGIERUNG ZUR HERSTELLUNG EINES LEITERGITTERS FÜR INTEGRIERTE SCHALTUNGEN UND HERSTELLUNGSVERFAHREN
HARDENED FE-NI ALLOY FOR MAKING INTEGRATED CIRCUIT GRIDS AND METHOD FOR MAKING SAME

(30) Priorité: 30.05.2000 FR 0006868
(43) Date de publication de la demande: 05.03.2003
(73) Titulaire: Aperam Alloys Imphy, 93200 Saint Denis (FR)
(72) Inventeur: COZAR, Ricardo, F-58160 La Fermeté (FR); REYDET, Pierre-Louis, F-58130 Montigny aux Amognes (FR)
(74) Mandataire: Neyret, Daniel Jean Marie
(86) Numéro de dépôt international: PCT/FR2001/001593
(87) Numéro de publication internationale: WO 2001/092587

(56) Documents cités:
- EP-A- 0 561 120
- EP-A- 0 723 030
- EP-A- 1 063 304
- DE-A- 3 636 815
- US-A- 5 325 911
- PATENT ABSTRACTS OF JAPAN vol. 013, no. 595 (C-672), 27 décembre 1989 (1989-12-27) -& JP 01 252725 A (NIPPON STEEL CORP), 9 octobre 1989 (1989-10-09)
- PATENT ABSTRACTS OF JAPAN vol. 1996, no. 08, 30 août 1996 (1996-08-30) -& JP 08 100242 A (HITACHI METALS LTD), 16 avril 1996 (1996-04-16)
- WEGST W ED - WEGST C W: "Stahlschlüssel", 1 January 1989 (1989-01-01), STAHLSCHLUSSEL. NACHSCHLAGEWERK; [STAHLSCHLUSSEL], MARBACH, VERLAG STAHLSCHLUSSEL WEGST, DE, PAGE(S) 6/07, XP002095653,

## Description

La présente invention est relative à un alliage Fe-Ni durci et à son procédé de fabrication sous forme de bandes minces utilisables notamment pour la fabrication de grilles support de circuits intégrés ou de grilles pour canon à électrons de tubes cathodiques de visualisation en couleur.

Dans les composants électronique comportant des circuits intégrés fabriqués à partir de pastilles de silicium, les pastilles de silicium sont collées sur des grilles appelées aussi « leadframe » destinées notamment à former les pattes de connexion des circuits intégrés. Ces grilles doivent être constituées d'un alliage ayant des propriétés multiples les rendant compatibles avec les pastilles de silicium et permettant la fabrication des composants dans de bonnes conditions. En particulier, l'alliage doit avoir un coefficient de dilatation thermique compatible avec celui du silicium afin d'éviter l'apparition de contraintes mécaniques importantes lors des cycles thermiques engendrés par les opérations de fabrication. L'alliage doit avoir une résistance mécanique suffisante pour que les pattes de connexion ne se déforment pas lors des manipulations au moyen d'automates, mais il doit être suffisamment ductile pour permettre la mise en forme par pliage de ces pattes. L'alliage doit également pouvoir être facilement découpé soit par découpe chimique soit par découpe mécanique et doit être peu oxydable en surface pour permettre de réaliser des dépôts électrolytiques dans de bonnes conditions.

Habituellement, les grilles support de circuits intégrés sont réalisées en alliage N42^{®} qui est un alliage Fe-Ni contenant environ 41% de Ni. Mais, cet alliage présente l'inconvénient d'avoir une résistance mécanique insuffisante pour réaliser les grilles des circuits intégrés minces dotés d'un grand nombre de pattes de connexion. Cette difficulté apparaît notamment pour les circuits intégrés dits « Quad Flat Pack » dont le nombre de pattes de connexion peut atteindre 240, ou les circuits intégrés dits « Thin Small Out Line Pack » dont l'épaisseur totale est de 1 mm.

Afin de remédier à cet inconvénient, et pour fabriquer des circuits intégrés minces comportant un grand nombre de pattes de connexion, on a proposé d'utiliser divers alliages Fe-Ni durcis qui présentent tous des inconvénients.

Par exemple :
- dans les demandes de brevet japonais J 04160112, J 04072037 et J 04099252, on a proposé d'utiliser des alliages Fe-Ni durcis par solution solide et consolidation par écrouissage, mais ces alliages ont une ductilité faible les rendant peu aptes à la mise en forme par pliage ;
- dans les demandes de brevet japonais J 03207835, J 03207834 et J 03173740, on a proposé d'utiliser des alliages Fe-Ni durci par précipitation homogène de phases NiBe ou γ' ou γ" par addition d'éléments tels que Be, Ti, Al, Nb ou Ta, mais ces alliages présentent l'inconvénient d'avoir une vitesse de découpe réduite et une sensibilité à l'oxydation de surface augmentée par rapport à celles de l'alliage N42 ;
- dans le brevet US 5,026,345, on a proposé d'utiliser un alliage Fe-Ni durci par formation de martensite d'écrouissage, mais cet alliage présente l'inconvénient d'avoir une ductilité faible et un coefficient de dilatation beaucoup plus élevé que celui du N42 ;
- dans la demande de brevet EP 0489932, on a proposé d'utiliser un alliage F-Ni durci par précipitation de carbures de Ti, Zr, Hf, V, Nb ou Ta et par consolidation par écrouissage, mais cet alliage a une sensibilité à l'oxydation de surface augmentée ce qui dégrade l'aptitude au dépôt électrolytique.

Aucun des alliages qui viennent d'être cités ne possède pleinement les propriétés souhaitées et le but de la présente invention est de remédier à cet inconvénient en proposant un alliage à haute limite d'élasticité mieux adapté à la fabrication de grilles support de circuits intégrés que les alliages connus.

A cet effet, l'invention a pour objet un procédé pour fabriquer une bande en alliage Fe-Ni dont la composition chimique comprend, en poids :
36% ≤ Ni + Co ≤43%
0%≤Co≤3%
0,05% ≤ C ≤ 0,4%
0,2% ≤Cr≤ 1,5%
0,4% ≤ Mo ≤ 3%
0% ≤ Cu ≤ 3%
Si ≤ 0.3%
Mn ≤ 0.3%
le reste étant du fer et des impuretés ; Cet alliage ayant une limite d'élasticité Rp0,2 supérieure à 750MPa et un allongement réparti Ar supérieur à 5%. De préférence, la 3 limite d'élasticité Rp0,2 est comprise entre 800 MPa et 1100 MPa et la résistance à la traction Rm est compris entre 900 MPa et 1130 MPa.

De préférence, la composition chimique est telle que :
38,5% ≤ Ni+Co ≤41%
0,1% ≤C ≤0,35%
0,5% ≤Cr ≤1,2%
1,5% ≤ Mo ≤2,5%

De préférence également, l'allongement réparti Ar est supérieur à 7%, la limite d'élasticité Rp0,2 est comprise entre 800 MPa et 1000 MPa et la résistance à la traction Rm est comprise entre 900 MPa et 1040 MPa.

Selon le procédé, pour fabriquer la bande :
- on élabore un alliage dont la composition chimique est conforme à l'analyse définie ci-dessus, éventuellement, on le refond sous vide ou sous laitier électroconducteur pour obtenir un demi-produit,
- on lamine à chaud le demi-produit à une température supérieure ou égale à 950°C pour obtenir une bande à chaud d'épaisseur comprise entre 2 et 6 mm, et de préférence entre 3 et 5 mm, le laminage à chaud étant éventuellement précédé d'un traitement d'homogénéisation par maintien au-dessus de 950°C ; après laminage, la bande est refroidie en dessous de 450°C à une vitesse de refroidissement suffisante pour éviter la précipitation de carbures,
- on lamine à froid la bande à chaud en une ou plusieurs réductions d'épaisseur de 5% à 95% séparées par des recuits à une température supérieure à 950°C,
- et on effectue un traitement thermique de durcissement entre 450°C et 850°C, le traitement thermique de durcissement étant précédé d'une réduction d'épaisseur d'au moins 40%.

Eventuellement, après le traitement thermique de durcissement, on effectue un laminage à froid complémentaire suivi d'un traitement thermique de restauration compris entre 550°C et 750°C.

L'invention concerne également une bande en alliage Fe-Ni conforme à l'invention, et notamment une bande dont l'épaisseur est supérieure ou égale à 50 µm et inférieure à 250 µm, dont la limite d'élasticité Rp0,2 est comprise entre 800 MPa et 1100 MPa, dont la résistance à la traction Rm est comprise entre 900 MPa et 1130 MPa et dont l'allongement est réparti Ar est supérieur ou égal à 5%. Cette bande peut être utilisée pour la fabrication d'une grille support de circuits intégrés ou pour la fabrication d'une grille de canon à électrons. On peut ainsi obtenir une grille support de circuit intégré en alliage dont le coefficient de dilatation thermique entre 20°C et 300°C est, de préférence, compris entre 4x10⁻⁶/K et 6x10⁻⁶/K.

L'invention va maintenant être décrite plus en détails et illustrée par des exemples.

L'alliage Fe-Ni objet de l'invention est un alliage Fe-Ni durci par précipitation de carbures de chrome et de molybdène dont la composition chimique comprend, en poids :
- plus de 36%, ou mieux, plus de 38,5%, mais moins de 43%, ou mieux moins de 41% de nickel, cet élément pouvant être remplacé partiellement par du cobalt à hauteur de 3% maximum (la teneur minimale en cobalt peut être égale à 0%) ; la teneur en nickel est choisie afin d'obtenir un coefficient de dilatation thermique entre 20°C et toute température T comprise entre 20°C et 300°C, compris entre 3,5x10⁻⁶ et 6,5x10⁻⁶ ;
- plus de 0,05%, ou mieux plus de 0,1%, mais moins de 0,4%, ou mieux, moins de 0,35% de carbone afin de permettre la formation de carbures durcissant par précipitation, sans détériorer le coefficient de dilatation et la ductilité de l'alliage ;
- plus de 0,2%, ou mieux plus de 0,5%, mais moins de 1,5% ou mieux moins de 1,2% de chrome, et plus de 0,4%, ou mieux plus de 1,5%, mais moins de 3% ou mieux moins de 2,5% de molybdène, afin de former des carbures durcissant par précipitation ; la somme Cr + Mo est limitée à 4,5% pour ne pas trop augmenter le coefficient de dilatation ;
- éventuellement jusqu'à 3% de cuivre (la teneur minimale étant 0% ou des traces) afin d'améliorer la résistance à la corrosion et à l'oxydation à l'air, ce qui améliore l'aptitude au dépôt électrolytique ;
- jusqu'à 0,3% de silicium et jusqu'à 0,3% de manganèse pour assurer la désoxydation au cours de l'élaboration ; les teneurs minimales en ces éléments étant des traces.

Le reste de la composition est constitué de fer et d'impuretés résultant de l'élaboration.

L'alliage est élaboré par exemple au four électrique à arc avec une phase d'affinage suivie d'une étape de métallurgie en poche chauffante ; il peut également être élaboré au four à induction sous vide. Cette élaboration doit être conduite, de préférence, de façon à obtenir un haut degré de pureté tel que les teneurs en S, P, N et O soient :
S < 0,01% et de préférence, < 0,002%
P < 0,02% et de préférence, < 0,008%
N < 0,01%
0<0,01%

L'alliage est alors coulé sous forme d'un demi-produit tel qu'une brame, une billette ou une électrode de refusion. Il peut être également coulé directement sous forme de bande mince d'épaisseur inférieure à 15 mm, et de préférence d'épaisseur comprise entre 8 mm et 12 mm.

Lorsque l'alliage est coulé sous forme d'électrode de refusion, celle-ci est refondue soit sous vide soit sous laitier électroconducteur afin d'obtenir une meilleure pureté et des demi-produits plus homogènes.

Le demi-produit, ou la bande mince obtenue par coulée directe, est laminé à chaud à une température supérieure à 950°C et de préférence supérieure à 1050°C, mais de préférence inférieure à 1300°C, pour obtenir une bande à chaud dont l'épaisseur est comprise entre 2 et 6 mm environ, et de préférence entre 3 et 5 mm. Les températures de laminage sont choisies afin d'éviter la précipitation de carbure et l'oxydation excessive de l'alliage. L'épaisseur de la bande à chaud est choisie en fonction des conditions du laminage à froid qui est effectué ultérieurement, de façon à pouvoir effectuer au moins une réduction d'épaisseur avec un taux de réduction supérieur à 40% (en particulier juste avant le traitement thermique de durcissement).

Le laminage à chaud peut être précédé d'un traitement thermique d'homogénéisation entre 950°C et 1300°C, ou mieux, entre 1050°C et 1200°C. Ce traitement peut durer de 30 minutes à 24 heures ou plus.

Après laminage, la bande a chaud est refroidie jusqu'à une température voisine de la température ambiante. Ce refroidissement doit être réalisé avec une vitesse de refroidissement entre la température de fin de laminage, qui doit rester supérieure à 950°C, et 450°C suffisante pour éviter la formation de carbures. Il est préférable que le temps de séjour entre 950°C et 450°C reste inférieur à 10 minutes et mieux inférieure à 5 minutes. Le refroidissement après laminage peut être effectué dans la chaude de laminage. Il peut être également constitué d'une hypertrempe réalisée après chauffage de la bande au-dessus de 950°C, ou mieux 1050°C, pour remettre en solution les carbures qui auraient pu s'être formés.

La bande à chaud est alors laminée à froid pour obtenir une bande à froid d'épaisseur comprise de préférence entre 50µm et 250µm, et par exemple entre 80µm et 150µm. Le laminage à froid se fait par une succession de réductions d'épaisseur de 5% à 95% séparées par des recuits à une température supérieure à 950°C, ou mieux 1050°C, pour éviter la formation de carbures et de préférence inférieure à 1200°C. Ce recuit est par exemple effectué dans un four à passage et dure de quelques secondes à quelques minutes.

En outre, on effectue sur la bande laminée à froid un traitement thermique de durcissement consistant en un ou plusieurs maintiens entre 450°C et 850°C destiné durcir par précipitation de carbures de chrome et de molybdène ; Il doit être réalisé sur du métal écroui avec un taux d'écrouissage supérieur à 40% et peut être suivi d'un laminage complémentaire. Ce traitement thermique peut être effectué soit au four statique, dans ce cas le maintien est effectué de préférence entre 450°C et 700°C pendant de 30 minutes à plusieurs heures, soit au four à passage, dans ce cas le maintien est effectué de préférence au-dessus de 700°C pendant environ 10 secondes à 10 minutes.

Lorsque le traitement thermique de durcissement est effectué sur la bande à l'épaisseur finale, la réduction d'épaisseur qui précède immédiatement le traitement thermique de durcissement doit être au moins de 40% et ne doit pas être suivie d'un recuit à 950°C.

Lorsque le traitement thermique de durcissement est effectué à une épaisseur supérieure à l'épaisseur finale, la réduction d'épaisseur qui précède immédiatement le traitement thermique de durcissement doit être au moins de 40% et ne doit pas être suivie d'un recuit au-dessus de 950°C, et le traitement thermique de durcissement est suivi directement par un laminage à froid complémentaire nécessaire pour obtenir l'épaisseur finale. Ce laminage à froid complémentaire ne doit pas comporter de recuit, mais il est suivi d'un traitement thermique de restauration compris entre 550°C et 750°C qui peut durer que quelques secondes à quelques minutes.

Par ce procédé, on obtient une bande à froid en alliage dont la limite d'élasticité Rp0,2 est supérieure à 750 MPa et l'allongement réparti Ar est supérieur à 5% (l'allongement réparti est l'allongement qui précède le début de la striction lors d'un essai de traction). En général la limite d'élasticité Rp0,2 est comprise entre 800 MPa et 1100 MPa, et la résistance à la rupture est comprise entre 900 MPa et 1130 MPa. Notamment pour le domaine de composition préférentiel, l'allongement à rupture peut être supérieur à 7%, en particulier lorsque l'épaisseur est supérieure ou égale à 100 µm (0,1 mm). La limite d'élasticité Rp0,2 peut être comprise entre 800 MPa et 1000 MPa, et la résistance à la rupture entre 900 MPa et 1040 MPa.

Cet alliage à un coefficient de dilatation thermique entre 20°C et toute température T comprise entre 20°C et 300°C compris entre 3,5x10⁻⁶ et 6,5x10⁻⁶. Lorsque la teneur en nickel est comprise entre 38,5% et 41%, le coefficient de dilatation thermique est compris entre 4x10⁻⁶/K et 6x10⁻⁶/K, de plus il varie très peu entre 20°C et 300°C, ce qui est un avantage pour les grilles support de circuits intégrés.

La bande ainsi obtenue peut être utilisée pour fabriquer par les procédés classiques connus en eux même de l'homme du métier des grilles support de circuits intégrés ou des grilles de canons à électrons pour tube cathodique de visualisation en couleur par exemple pour la télévision. Avantageusement, on peut utiliser des bandes d'épaisseur comprise entre 80 µm et 125 µm ayant un allongement à rupture supérieur à 5%, ou mieux supérieur à 7%, pour fabriquer des grilles support de circuits intégrés. De préférence, la composition de l'alliage est choisie afin que le coefficient de dilatation thermique varie le moins possible entre 20°C et 300°C, et pour qu'il reste compris entre 4x10⁻⁶/K et 6x10⁻⁶/K.

A titre d'exemple, on a élaboré les alliages A1 à A12 conformes à l'invention et les alliages B, C et D conformes à l'art antérieur (B correspond au N42^{®}, C au N42Nb et D au N42-γ').

Les compositions chimiques de ces alliages (en % en poids) sont reportées au tableau 1.

Les alliages A1, A2 et B ont été élaborés au four à arc, les alliages A3 à A12, C et D ont été élaborés au four à induction sous vide.

Les demi-produits ont été homogénéisés entre 1050°C et 1200°C pendant 2 à 5 heures, puis laminés à chaud au-dessus de 950°C et les bandes en alliages A1 à A12 ont été hypertrempées à partir d'une température de 1050°C.

Les bandes en alliage A1 à A12 ont été laminées à froid selon une gamme de laminage LA, l'alliage A2 a également été laminé à froid selon une gamme LB.

La gamme de laminage à froid LA comporte une succession de réductions d'épaisseur séparées par des recuits de recristallisation au-dessus de 1050°C, la dernière réduction d'épaisseur se faisant avec un taux de réduction τ₁ supérieur à 40%, et suivi d'un traitement thermique de durcissement à une température T₁.

La gamme de laminage à froid LB comporte une première partie identique à la gamme LA et une deuxième partie constitué d'un laminage à froid complémentaire correspondant à un taux de réduction d'épaisseur τ₂ suivi d'un recuit de restauration à une température T₂.

Les alliages B et C ont été laminés selon une gamme usuelle comportant une succession de réductions d'épaisseur séparées par des recuits de recristallisation et terminée par une réduction d'épaisseur correspondant à un taux d'écrouissage supérieur à 10%. L'alliage D a été laminé selon une gamme se différentiant de la gamme LA par le taux d'écrouissage avant traitement de durcissement qui a été de 25%, et par un traitement de durcissement effectué à 750°C pendant 2 minutes pour provoquer un durcissement par précipitation de phase γ'.

Dans tous les cas l'épaisseur finale de la bande était comprise entre 100 µm et 150 µm (entre 0,1 et 0,15 mm).

**Tableau 1**

| alliage | Ni | Cr | Mo | Si | Mn | C | S | Autres |
|---|---|---|---|---|---|---|---|---|
| A1 | 37,6 | 0,78 | 2,05 | 0,18 | 0,19 | 0,24 | 0,0010 | |
| A2 | 37,9 | 0,80 | 2,07 | 0,17 | 0,19 | 0,24 | 0,0010 | |
| A3 | 38,8 | 0,83 | 2,05 | 0,15 | 0,19 | 0,25 | 0,0009 | |
| A4 | 39,7 | 0,81 | 2,04 | 0,14 | 0,19 | 0,24 | 0,0008 | |
| A5 | 40,8 | 0,80 | 2,03 | 0,14 | 0,19 | 0,23 | 0,0008 | |
| A6 | 41,7 | 0,79 | 2,03 | 0,15 | 0,25 | 0,24 | 0,0008 | |
| A7 | 37,2 | 0,93 | 2,08 | 0,15 | 0,2 | 0,17 | 0,0009 | |
| A8 | 37,5 | 0,82 | 2,09 | 0,15 | 0,2 | 0,29 | 0,0009 | |
| A9 | 37,5 | 0,82 | 1,7 | 0,15 | 0,2 | 0,24 | 0,0009 | |
| A10 | 37,4 | 0,81 | 2,5 | 0,15 | 0,2 | 0,24 | 0,0009 | |
| A11 | 37,6 | 0,66 | 2,09 | 0,15 | 0,2 | 0,24 | 0,0009 | |
| A12 | 37,5 | 0,96 | 2,11 | 0,15 | 0,2 | 0,24 | 0,0009 | |
| B | 40,8 | - | - | 0,1 | 0,45 | 0,002 | 0,0005 | |
| C | 41 | - | - | 0,1 | 0,4 | 0,001 | 0,0005 | Nb:2 |
| D | 41,5 | - | - | 0,1 | 0,4 | 0,001 | 0,0005 | TI: 2.6; Al: 2 |

Les caractéristiques mécaniques obtenues sur les bandes en alliage A2 sont reportées au tableau 2.

Ces résultats montrent notamment que dans tous les cas, l'allongement réparti est très supérieur à 5% et même à 7%, alors que la limite d'élasticité est nettement supérieure à 750MPa.

Les caractéristiques mécaniques obtenues sur les alliages A1, A7 à A12 et B, sont reportées au tableau 3.

On constate sur ces résultats, qu'avec l'alliage selon l'invention, la limite d'élasticité est toujours supérieure à 750MPa et l'allongement réparti est très supérieur à 5%, alors que l'alliage B, l'allongement réparti n'est supérieur à 5% que lorsque la limite d'élasticité est inférieure à 700MPa.

**Tableau 2**

| gamme | τ₁% | T₁°C, temps | τ₂ % | T₂°C; temps | Rp0,2 (MPa) | Rm (MPa) | Ar (%) |
|---|---|---|---|---|---|---|---|
| LA | 73 | 700°-1,4 min | | | 1013 | 1090 | 7,9 |
| LA | 73 | 750°-1,4 min | | | 885 | 994 | 10 |
| LA | 73 | 800°-1,4 min | | | 766 | 922 | 15 |
| LA | 73 | 700°- 0,6 min | | | 1024 | 1100 | 8,5 |
| LA | 73 | 750°- 0.6 min | | | 870 | 992 | 12 |
| LA | 73 | 750°- 0,3 min | | | 922 | 1028 | 10 |
| LA | 73 | 800-0,6 min | | | 778 | 928 | 13 |
| LB | 70 | 700°- 4 min | 60 | 550°- 1,4 min | 1071 | 1152 | 6 |
| LB | 70 | 750°- 4 min | 60 | 650°-1,4 min | 1058 | 1134 | 7,7 |
| LB | 70 | 800°- 4 min | 60 | 700°-1,4 min | 1010 | 1114 | 9 |
| LB | 70 | 700°- 4 min | 60 | 550°- 1,4 min | 1054 | 1116 | 7 |
| LB | 70 | 750°-4 min | 60 | 650°-1,4 min | 1006 | 1098 | 9,2 |
| LB | 70 | 800°- 4 min | 60 | 700°-1,4 min | 950 | 1058 | 9,5 |

On a également mesuré les coefficients de dilatation moyens α₂₀¹⁰⁰ entre 20°C et 100°C et le coefficient moyen de dilatation thermique α₂₀²⁰⁰ entre 20°C et 200°C. Les résultats sont reportés au tableau 4 et au tableau 5.

Ces résultats montrent, en particulier, que le coefficient de dilatation reste compris entre 3,5x10⁻⁶/K et 6,5x10⁻⁶/K, et que pour les alliages A3 et A4 au moins, le coefficient de dilatation thermique varie très peu sur la plage 20°C/300°C.

**Tableau 3**

| Alliage | τ₁% | T₁ °C, temps | Rp0,2 (MPa) | Rm (MPa) | Ar % |
|---|---|---|---|---|---|
| A1 | 75 | 700° - 3 h | 890 | 1016 | 9,5 |
| A1 | 75 | 700°-5h | 802 | 961 | 11 |
| A7 | 75 | 625°-1h+ 700° - 3h | 798 | 959 | 11 |
| A8 | 75 | 625°-1h+ 700° - 3h | 824 | 1018 | 9,5 |
| A9 | 75 | 625°-1h+700°-3h ' | 842 | 1035 | 9 |
| A10 | 75 | 625°-1h+ 700° - 3h | 814 | 1048 | 8,5 |
| A11 | 75 | 625°-1h+ 700° - 3h | 854 | 1047 | 8,5 |
| A12 | 75 | 625°-1h+ 700° - 3h | 830 | 1041 | 9 |
| B | 10 | - | 460 | 560 | 18 |
| B | 20 | - | 580 | 620 | 12 |
| B | 40 | - | 680 | 700 | 7 |
| B | 60 | - | 740 | 760 | 4 |
| B | 80 | - | 820 | 830 | 2 |

**Tableau 4**

| gamme | Alliage | τ₁% | T₁ °C, temps | τ₂% | T₂ °C, temps | α₂₀¹⁰⁰ (10-6/K) | α₂₀²⁰⁰(10-6/K) |
|---|---|---|---|---|---|---|---|
| LA | A2 | 70 | 750°- 4min | | | 3,8 | 4,0 |
| LA | A2 | 70 | 800°- 4min | | | 3,6 | 3,8 |
| LB | A2 | 70 | 800°- 4min | 60 | 550°-1,4min | 3,2 | 3,5 |
| LB | A2 | 70 | 800°- 4min | 60 | 550°-1,4min | 3,5 | 3,7 |
| LB | A2 | 70 | 800°-4min | 60 | 550°-1,4min | 3,5 | 3,7 |
| LA | A3 | 78 | 800°- 5min | | | 4,6 | 4,6 |
| LA | A4 | 70 | 800°- 5min | | | 5,1 | 5,0 |
| LA | A5 | 75 | 800°-5min | | | 5,6 | 5,5 |
| LA | A6 | 70 | 800°- 5min | | | 6,4 | 6,3 |

**Tableau 5**

| gamme | Alliage | τ₁% | T₁ °C, temps | α₂₀¹⁰⁰ | α₂₀²⁰⁰ |
|---|---|---|---|---|---|
| LA | A7 | 75 | 625°-1h+700°-3h | 3,3 | |
| LA | A8 | 75 | 625°-1h+700°-3h | 3,2 | |
| LA | A9 | 75 | 625°-1h+700°-3h | 3,3 | |
| LA | A10 | 75 | 625°-1h+700°-3h | 3,3 | |
| LA | A11 | 75 | 625°-1h+700°-3h | 3,2 | |
| LA | A12 | 75 | 625°-1h+700°-3h | 3,4 | |
| usuelle | B | 25 | | 4,3 | 4,1 |

On a également fait des mesures de vitesse d'attaque chimique pour évaluer l'aptitude au découpage chimique. Ces essais ont été faits en immergeant des échantillons d'alliages A2, B et C dans une solution acide FeCl₃/6H₂O : 550g/l + HCl, d=1,18 : 10ml/l.

Ces essais ont montré que pour l'alliage A2 et l'alliage B, au bout de 8 minutes d'immersion, la vitesse moyenne d'attaque est de 8,2 µg/min.mm² environ, alors qu'elle n'est que de 6,7 µg/min.mm² pour l'alliage C.

L'aptitude au découpage mécanique de l'alliage A2 et de l'alliage B ont été comparées sur des bandes de 0,1mm d'épaisseur en mesurant d'une part le rapport h/e de la hauteur moyenne de la zone de rupture à cupule à l'épaisseur de la bande, d'autre part la dispersion σ de ce rapport. L'alliage A2 a été laminé selon la gamme LA avec un taux de réduction τ₁ de 73% et un recuit de durcissement à 750°C pendant 0,3 min ou à 800°C pendant 0,3 min.

Pour l'alliage A2 le rapport h/e est de 0,25 et la dispersion σ est de 0,06, alors que pour l'alliage B, le rapport h/e varie de 0,22 à 0,31 et la dispersion σ est de 0,10. Les rapports h/e étant en moyenne comparables, la plus faible dispersion σ de l'alliage A2 montre que celui-ci a une aptitude à la découpe mécanique meilleure que celle de l'alliage B.

On a, enfin comparé la sensibilité des alliages A, B, C et D à l'oxydation en mesurant l'épaisseur de la couche oxydée en surface, exprimée en nanomètres (nm), en fonction de la durée d'un traitement thermique sous air à 420°C sur des états écrouis.

On a obtenu les résultats reportés au tableau 6.

**Tableau 6**

| Alliage | τ₁ % | 1 min à 420°C | 3 min à 420°C | 10 min à 420°C |
|---|---|---|---|---|
| A2 | 72 | 51 | 103 | 188 |
| B | 25 | 102 | 185 | 310 |
| C | 17 | 154 | 218 | 341 |
| D | 20 | 126 | 167 | 241 |

Ces résultats montrent que l'alliage A2 est moins facilement oxydable que les alliages selon l'art antérieur, ce qui est favorable à une bonne aptitude au revêtement par électrolyse. Cette aptitude a été confirmée par des tests de revêtement pour les revêtements suivants : Sn60-Pb40, pré Ni et argenture totale, pré Ni et dorure sélective, pré Ni et argenture sélective, cuivrage et argenture sélective. Dans tous les cas, les résultats ont été satisfaisants : l'épaisseur était contrôlée, il n'y avait pas de cloques et l'adhérence était bonne.

L'ensemble de ces résultats montre que l'alliage selon l'invention présente une meilleure aptitude à la fabrication de grilles support de circuits intégrés que les alliages selon l'art antérieur. De même, cet alliage est bien adapté à la fabrication de grilles pour canon à électrons de tubes cathodiques. Les grilles support de circuits intégrés et les canons à électrons sont des objets bien connus en eux même.

## Revendications

1. Procédé pour la fabrication d'une bande en alliage Fe-Ni dont la limite d'élasticité Rp0,2 supérieure à 750 MPa et l'allongement réparti Ar supérieur à 5%, selon lequel :
- on élabore un alliage dont la composition chimique comprend, en poids :
36% ≤ Ni + Co ≤ 43%
0% ≤ Co ≤ 3%
0,05% ≤ C ≤ 0,4%
0,2% ≤ Cr≤1,5%
0,4% ≤ Mo ≤ 3%
Cu ≤ 3%
Si ≤ 0,3%
Mn ≤ 0,3%
le reste étant du fer et des impuretés,
- éventuellement, on le refond sous vide ou sous laitier électroconducteur pour obtenir un demi-produit,
- on lamine à chaud le demi-produit à une température supérieure ou égale à 950°C pour obtenir une bande à chaud d'épaisseur comprise entre 2 et 6 mm, le laminage à chaud étant éventuellement précédé d'un traitement d'homogénéisation par maintien au-dessus de 950°C, après laminage, la bande est refroidie en dessous de 450°C à une vitesse de refroidissement suffisante pour éviter la précipitation de carbures,
- on lamine à froid la bande à chaud en une ou plusieurs réductions de 5% à 95% séparées par des recuits à une température supérieure à 950°C,
- et on effectue un traitement thermique de durcissement entre 450°C et 850°C, le traitement thermique de durcissement étant précédé d'une réduction d'au moins 40%.

2. Procédé selon la revendication 1 dans lequel, après le traitement thermique de durcissement, on effectue un laminage à froid complémentaire suivi d'un traitement thermique de restauration compris entre 550°C et 750°C.

3. Procédé selon la revendication 1 ou la revendication 2 dans lequel la composition chimique de l'alliage est telle que :
38,5% ≤ Ni + Co ≤ 41 %
0,1% ≤ C s 0,35%
0,5% ≤ Cr ≤ 1,2%
1,5% ≤ Mo ≤ 2,5%

4. Bande dont la composition chimique est conforme à la composition chimique définie à la revendication 1 ou à la revendication 3, dont la limite d'élasticité Rp0,2 est comprise entre 800 MPa et 1000 MPa, la résistance à la traction Rm est comprise entre 900 MPa et 1130 MPa et l'allongement réparti est supérieur à 7%, et dont l'épaisseur est supérieure à 50 µm et inférieure à 250 µm.

5. Utilisation d'une bande en alliage dont la composition chimique est conforme à la composition chimique selon la revendication 1 ou la revendication 3, dont la limite d'élasticité Rp0,2 est comprise entre 800 MPa et 1100 MPa et la résistance à la traction Rm est comprise entre 900 MPa et 1130 MPa, pour la fabrication d'une grille support de circuit intégré.

6. Utilisation d'une bande selon la revendication 5 **caractérisé en ce que** limite d'élasticité Rp0,2 est comprise entre 800 MPa et 1000 MPa et la résistance à la traction Rm est comprise entre 900 MPa et 1130 MPa et l'allongement réparti est supérieur à 7%.

7. Utilisation d'une bande selon la revendication 5 ou 6, **caractérisé en ce que** l'épaisseur de la bande est supérieure à 0,1 mm.

8. Grille support de circuit intégré fabriqué par l'utilisation d'une bande selon l'une quelconque des revendications 5 à 7.

9. Grille support de circuit intégré selon la revendication 8, **caractérisé en ce que** l'alliage a un coefficient de dilatation thermique entre 20°C et 300°C compris entre 4x10⁻⁶/K et 6x10⁻⁶/K.

10. Grille de canon à électrons par exemple pour tube de télévision en couleur fabriqué par l'utilisation d'une bande selon la revendication 4.

## Claims

1. A process for manufacturing a strip made of an Fe-Ni alloy having a yield strength R_{p0.2} greater than 750 MPa and a uniform elongation Aᵣ greater than 5%, according to which:
an alloy is smelted whose chemical composition comprises, by weight:
36% ≤ Ni + Co ≤ 43%
0% ≤ Co ≤ 3%
0.05% ≤ C ≤ 0.4%
0.2% ≤ Cr ≤ 1.5%
0.4% ≤ Mo ≤ 3%
Cu ≤ 3%
Si ≤ 0.3%
Mn ≤ 0.3%,
the balance being iron and impurities;
- optionally, said alloy is vacuum remelted or electroslag remelted in order to obtain a semifinished product;
- the semifinished product is hot rolled at a temperature greater than or equal to 950°C in order to obtain a hot-rolled strip having a thickness of between 2 and 6 mm, and preferably between 3 and 5 mm, the hot rolling optionally being preceded by a homogenization treatment by a soak above 950°C; after rolling, the strip is cooled to below 450°C at a cooling rate sufficient to avoid the precipitation of carbides;
- the hot-rolled strip is cold rolled in one or more 5% to 95% reduction steps separated by anneals at a temperature greater than 950°C; and
- a hardening heat treatment is carried out between 450°C and 850°C, the hardening heat treatment being preceded by an at least 40% reduction step.

2. The process as claimed in claim 1, **characterized in that**, after the hardening heat treatment, a supplementary cold-rolling operation is carried out followed by a recovery heat treatment between 550°C and 750°C.

3. The process as claimed in claim 1 or claim 2, in which the chemical composition of the alloy is such that:
38.5% ≤ Ni + Co ≤ 41%
0.1% ≤ C ≤ 0.35%
0.5% ≤ Cr ≤ 1.2%
1.5% ≤ Mo ≤ 2.5%.

4. A strip, the chemical composition of which is according to the chemical composition as defined in claim 1 or claim 3, the yield strength R_{p0.2} of which is between 800 MPa and 1000 MPa, the tensile strength Rₘ of which is between 900 MPa and 1130 MPa, and the uniform elongation of which is greater than 7%, and the thickness of which is higher than 50 µm and lower than 250 µm.

5. The use of a strip made of an alloy, the chemical composition of which is as defined in claim 1 or claim 3, the yield strength R_{p0.2} of which is between 800 MPa and 1100 MPa, the tensile strength Rₘ of which is between 900 MPa and 1130 MPa, for the manufacturing of an integrated circuit leadframe.

6. The use of a strip as claimed in claim 5, **characterized in that** the yield strength R_{p0.2} is between 800 MPa and 1000 MPa, the tensile strength Rₘ is between 900 MPa and 1130 MPa, and the uniform elongation of is greater than 7%.

7. The use of a strip as claimed in one of claims 5 or 6, **characterized in that** the thickness of the strip is greater than 0.1 mm.

8. An integrated circuit leadframe manufactured from the use of a strip as claimed in any one of claims 5 to 7.

9. An integrated circuit leadframe as claimed in claim 8, **characterized in that** the alloy has a thermal expansion coefficient between 20°C and 300°C of between 4×10⁻⁶/K and 6×10⁻⁶/K.

10. An electron gun grid, for example for color television tubes, manufactured from the use of a strip as claimed in claim 4.

## Patentansprüche

1. Verfahren für die Herstellung eines Bandes aus einer Fe-Ni-Legierung, dessen Elastizitätsgrenze Rp0,2 größer ist als 750 MPa und dessen verteilte Dehnung Ar größer ist als 5 %, wobei:
- eine Legierung erstellt wird, deren chemische Zusammensetzung bezogen auf das Gewicht umfasst:
36% ≤ Ni + Co ≤ 43 %
0% ≤ Co ≤ 3 %
0,05% ≤ C ≤ 0,4%
0,2% ≤ Cr ≤ 1,5%
04% ≤ Mo≤3 %
Cu ≤ 3%
Si ≤ 0,3 %
Mn ≤ 0,3 %
wobei der Rest Eisen und Verunreinigungen ist,
- sie eventuell unter Vakuum oder unter elektrisch leitender Schlacke umgeschmolzen wird, um ein Halberzeugnis zu erhalten,
- das Halberzeugnis bei einer Temperatur oberhalb oder gleich 950 °C warmgewalzt wird, um ein warmes Band mit einer Dicke zwischen 2 und 6 mm zu erhalten, wobei dem Warmwalzen eventuell eine Homogenisierungsbehandlung durch Halten über 950 °C vorangeht, nach dem Walzen das Band unter 450 °C mit einer Abkühlgeschwindigkeit abgekühlt wird, die ausreicht, um die Ausfällung von Carbiden zu vermeiden,
- das warme Band in einer oder mehreren Reduktionen von 5 % bis 95 % kaltgewalzt wird, die durch Glühvorgänge bei einer Temperatur oberhalb 950 °C getrennt sind,
- und eine Härtungswärmebehandlung zwischen 450 °C und 850 °C durchgerührt wird, wobei der Härtungswärmebehandlung eine Reduktion von mindestens 40 % vorangeht.

2. Verfahren nach Anspruch 1, wobei nach der Härtungswärmebehandlung zusätzliches Kaltwalzen, gefolgt von einer Erholungswärmebehandlung zwischen 550 °C und 750 °C, durchgeführt wird.

3. Verfahren nach Anspruch 1 oder Anspruch 2, wobei die chemische Zusammensetzung der Legierung derart ist:
38,5%≤Ni+Co≤41 %
0,1%≤C≤0,35%
0,5%≤Cr≤1,2%
1,5 %≤Mo≤2,5%

4. Band, dessen chemische Zusammensetzung der in Anspruch 1 oder Anspruch 3 definierten chemischen Zusammensetzung entspricht, dessen Elastizitätsgrenze Rp0,2 zwischen 800 MPa und 1000 MPa liegt, dessen Zugfestigkeit Rm zwischen 900 MPa und 1130 MPa liegt und dessen verteilte Dehnung größer ist als 7 % und dessen Dicke größer als 50 µm und kleiner als 250 µm ist.

5. Verwendung eines Bandes aus einer Legierung, deren chemische Zusammensetzung der chemischen Zusammensetzung nach Anspruch 1 oder Anspruch 3 entspricht, dessen Elastizitätsgrenze Rp0,2 zwischen 800 MPa und 1100 MPa liegt und dessen Zugfestigkeit Rm zwischen 900 MPa und 1130 MPa liegt, für die Herstellung eines Stützgitters einer integrierten Schaltung.

6. Verwendung eines Bandes nach Anspruch 5, **dadurch gekennzeichnet, dass** die Elastizitätsgrenze Rp0,2 zwischen 800 MPa und 1000 MPa liegt und die Zugfestigkeit Rm zwischen 900 MPa und 1130 MPa liegt und die verteilte Dehnung größer ist als 7 %.

7. Verwendung eines Bandes nach Anspruch 5 oder 6, **dadurch gekennzeichnet, dass** die Dicke des Bandes größer ist als 0,1 mm.

8. Stützgitter einer integrierten Schaltung, das durch die Verwendung eines Bandes nach einem der Ansprüche 5 bis 7 hergestellt wird.

9. Stützgitter einer integrieren Schaltung nach Anspruch 8, **dadurch gekennzeichnet, dass** die Legierung zwischen 20 °C und 300 °C einen Wärmeausdehnungskoeffizienten zwischen 4x 10⁻⁶/K und 6x 10⁻⁶/K aufweist.

10. Elektronenkanonengitter beispielsweise für eine Farbfernsehröhre, das unter Verwendung eines Bandes nach Anspruch 4 hergestellt wird.
